# EUROPEAN PATENT SPECIFICATION

(11) **EP 4 378 882 B1**
(45) Date of publication and mention of the grant of the patent: **01.04.2026**
(21) Application number: 22210912.6
(22) Date of filing: 01.12.2022
(51) Int. Cl.: B81B 7/00

(54) **MICROMECHANICAL ENVIRONMENTAL BARRIER CHIP AND METHOD FOR MANUFACTURING SAME**
MIKROMECHANISCHER UMWELTBARRIERECHIP UND HERSTELLUNGSVERFAHREN DAFÜR
PUCE MICROMÉCANIQUE BARRIÈRE ENVIRONNEMENTALE ET SON PROCÉDÉ DE FABRICATION

(43) Date of publication of application: 05.06.2024
(73) Proprietor: Infineon Technologies AG, 85579 Neubiberg (DE)
(72) Inventor: WASISTO, Hutomo Suryo, 81541 München (DE); STREB, Fabian, 93059 Regensburg (DE); ANZINGER, Sebastian, 83714 Miesbach (DE); FUELDNER, Marc, 85579 Neubiberg (DE); MAIER, Dominic, 92714 Pleystein (DE)
(74) Representative: Hersina, Günter

(56) References cited:
- EP-A1- 3 680 212
- WO-A1-2017/114881
- WO-A1-99/24141
- US-A1- 2012 040 581
- US-A1- 2013 264 663

## Description

Embodiments of the present disclosure relate to a micromechanical environmental barrier chip for providing a protection for MEMS microphones or MEMS speakers against ingress of environmental solid, gaseous and/or moist particles. Further embodiments relate to a manufacturing method thereof.

### TECHNICAL BACKGROUND

Despite their wide employment in several acoustic applications like smartphones, true wireless (TWS) earphones, etc., current microelectromechanical system (MEMS)-based microphones are prone to influences from dust particles, moisture, and other physical or chemical objects, which consequently result in a lower robustness and shortened lifetime of the devices.

Currently available solutions from microphone manufacturers, such as disclosed in US 2013 / 0 264 663 A1 or US 2012 / 0 040 581 A1, rely on external and large environmental barriers (EBs) that are placed far away from the microphone chips, leading to high production cost, large package size, low acoustic performance, and limited usage for applications.

Thus, it would be desirable to provide a microstructured environmental barrier for MEMS-based acoustic elements, said environmental barrier comprising a small form factor while providing reliable and robust protection against ingress of environmental solid, gaseous and/or moist particles. It would further be desirable to provide a manufacturing method thereof that enables a reduction in production costs.

These goals can be achieved with a method for manufacturing a micromechanical environmental barrier chip according to the method of the invention as set out in claim 1. Acorrdingly, said method comprises a step of providing a substrate having a first surface and an opposite second surface, a step of depositing a material layer onto the first surface of the substrate, the material layer having a different etch rate than the substrate, and a step of creating an air permeable microstructured micromechanical environmental barrier structure on top of the material layer by applying a microstructuring process. The method further comprises a step of applying an anisotropic etching process comprising at least one etching step for anisotropically etching from the second surface towards the first surface of the substrate so as to create at least a first cavity underneath the micromechanical environmental barrier structure, the cavity extending between the second surface and the material layer. The method further comprises a step of removing the material layer residing inside the cavity in order to expose the environmental barrier structure. The method further comprises a step of applying nanofibers onto the micromechanical environmental barrier structure, such that the nanofibers combine to form an air permeable nanofibrous membrane structure. The invention also provides a micromechanical environmental barrier chip manufactured by the method of the invention.

In the following, embodiments of the present disclosure are described in more detail with reference to the figures, in which
- Fig. 1: shows a schematic block diagram of a method for manufacturing a micromechanical environmental barrier chip according to an embodiment,
- Figs. 2A-2C: show a method step by means of a top view, a cross-sectional view and a perspective view, respectively, of an unprocessed substrate,
- Figs. 3A-3C: show a further method step of applying a material layer on the substrate by means of a top view, a cross-sectional view and a perspective view, respectively, of the substrate,
- Figs. 4A-4C: show a further method step of creating an environmental barrier structure on top of the material layer by means of a top view, a cross-sectional view and a perspective view, respectively, of the substrate,
- Figs. 5A-5C: show a further method step of creating a cavity in the substrate by means of a top view, a cross-sectional view and a perspective view, respectively, of the substrate,
- Figs. 6A-6C: show a further method step of applying nanofibers onto the environmental barrier structure by means of a top view, a cross-sectional view and a perspective view, respectively, of the substrate,
- Fig. 7A: shows a perspective view of an environmental barrier chip with nanofibers applied thereon,
- Fig. 7B: shows an exploded view of the environmental barrier chip of Figure 7A,
- Fig. 8A: shows a top view onto the environmental barrier chip of Figure 7A,
- Fig. 8B: shows a cross-sectional view along the cross-sectional line B-B in Figure 8A,
- Fig. 9A: shows a top view onto the environmental barrier chip of Figure 7A,
- Fig. 9B: shows a cross-sectional view along the cross-sectional line C-C in Figure 9A,
- Fig. 10: shows a cross-sectional view of an environmental barrier chip according to a further embodiment,
- Fig. 11: shows a sequence of method steps for creating the environmental barrier chip of Figure 10,
- Figs. 12A-12D: show top views of an environmental barrier chip with micro beams according to embodiments,
- Fig. 12E: shows a cross-sectional view of the environmental barrier chip of Figure 12A along the cross-sectional line F-F,
- Fig. 12F: shows a cross-sectional view of the environmental barrier chip of Figure 12A along the cross-sectional line G-G,
- Fig. 13: shows a cross-sectional view and a top view of an environmental barrier chip according to an embodiment,
- Figs. 14A-14E: show different packaging concepts,
- Fig. 15A: shows a perspective view of an environmental barrier chip according to an example,
- Fig. 15B: shows a picture of the environmental barrier chip taken with a raster electron microscope,
- Fig. 15C: shows a graphical illustration of a simulation for comparing square grid size against SNR loss, and
- Fig. 15D: shows a further graphical illustration of a simulation for comparing square grid size against SNR loss.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

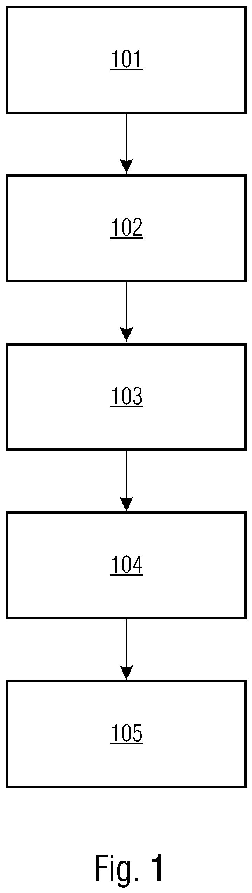

Figure 1 shows a schematic block diagram of the method of the invention according to an embodiment. The single method steps may be executed in a different order than depicted and described in the following.

In block 101, a substrate is provided, said substrate having a first surface and an opposite second surface.

In block 102 a material layer is deposited onto the first surface of the substrate, the material layer having a different etch characteristic than the substrate. An etch characteristic may include a certain selectivity. The selectivity describes an etch ratio between two different materials. For example, if the selectivity is 2:1, then a first material will be etched/removed two times faster than a second material, when applying the same etching process for the same time duration on both materials.

In block 103 an air permeable microstructured micromechanical environmental barrier structure is provided on top of the material layer by applying a microstructuring process.

In block 104 an anisotropic etching process is performed comprising at least one etching step for anisotropically etching through the substrate (e.g. from the second surface towards the first surface of the substrate) until reaching the material layer so as to create at least a first cavity opposite (e.g. underneath) the micromechanical environmental barrier structure, the cavity extending between the second surface and the material layer.

In block 105 any of the material layer that resides inside the cavity is removed in order to expose the environmental barrier structure, and nanofibers are applied onto the micromechanical environmental barrier structure, such that the nanofibers combine to form an air permeable nanofibrous membrane structure.

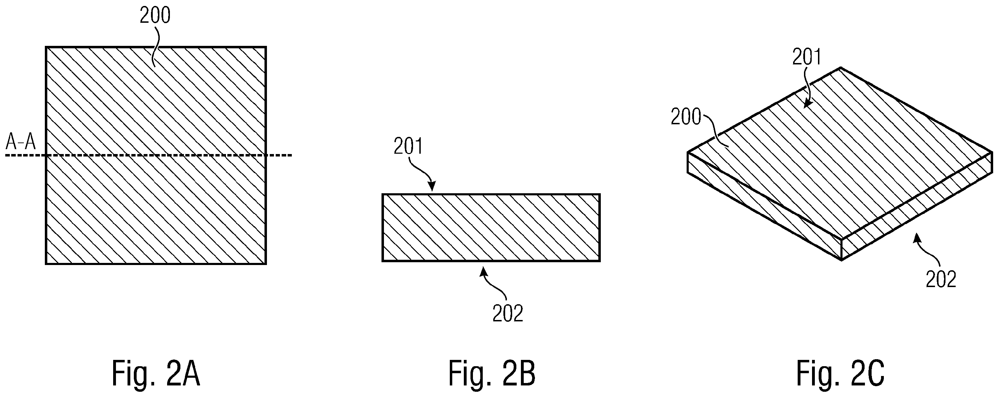

Figures 2A to 6C show a structural description of the method of the invention. Figures 2A, 3A, 4A and 5A show a top view onto the substrate 200 to be processed. Figures 2B, 3B, 4B and 5B show a cross-sectional view along the section line A-A. Figures 2C, 3C, 4C and 5C show a perspective view of the substrate 200.

Starting with Figures 2A to 2C, a substrate 200 is depicted, the substrate 200 having a first surface 201 and an opposite second surface 202. The substrate 200 may consist of, or comprise, a semiconductor material, such as silicon, for example. Alternatively, the substrate 200 may consist of, or comprise, glass, (poly-)imide, plastics or the like. The substrate 200 may be flexible or rigid.

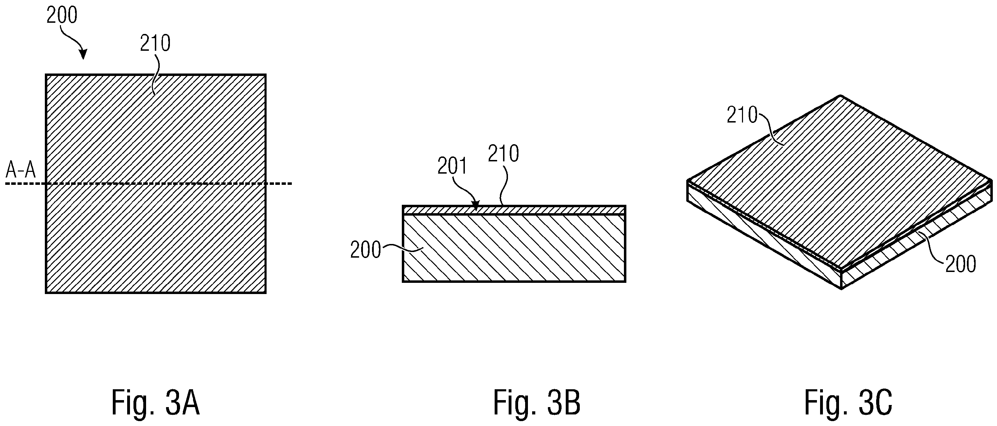

Figures 3A to 3C show a further method step. A material layer 210 is deposited onto the first surface 201 of the substrate 200. The material layer 210 may be deposited completely over the entire first surface 201. The material layer 210 has a different etch characteristic than the substrate 200. For example, the material layer 210 and the substrate 200 may comprise a high selectivity for one and the same etchant. The selectivity describes the etch ratio between the material layer 210 and the substrate 200. For example, the substrate 200 may be etched/removed significantly faster than the material layer 210. In some embodiments, the substrate 210 may be completely removed while the material layer 210 is not noticeably etched/removed.

Accordingly, as will be explained in more detail below, the material layer 210 may serve the purpose of an etch stop layer. For example, the material layer 210 may consist of or comprise tetraethyl orthosilicate, formally named tetraethoxysilane (TEOS), or other oxide (e.g., thermal silicon dioxides - SiO₂ -, atomic layer deposited oxide) and nitride (e.g., silicon nitride) materials. These materials have an insulating characteristic. For example, the etch rate between TEOS (as the material layer 210) and silicon (substrate 200) is about 1:100, i.e., silicon is etched/removed a hundred times faster than TEOS.

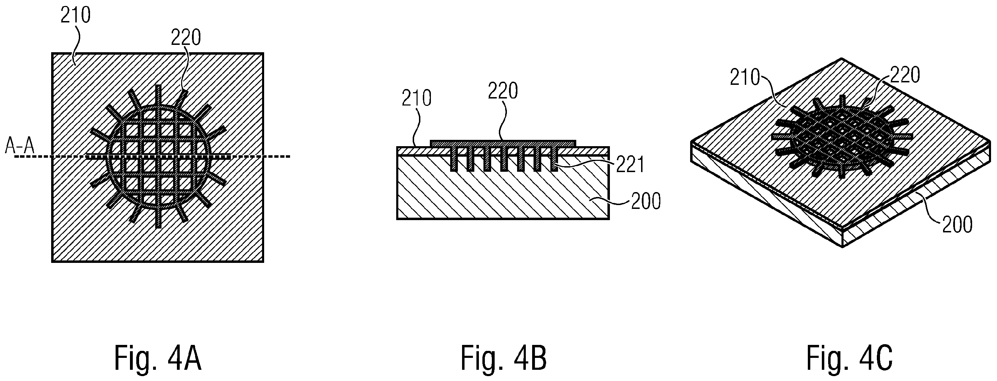

Figures 4A to 4C show a further method step. An air permeable microstructured micromechanical environmental barrier structure 220 is created on top of the material layer 210. The micromechanical environmental barrier structure 220 is formed by applying a microstructuring process, e.g., a surface MEMS micromachining process. The micromechanical environmental barrier structure 220 may be provided as an air permeable mesh, as depicted, or as a perforated air permeable membrane.

The micromechanical environmental barrier structure 220 may comprise a circular or rectangular shape, while other geometrical shapes are possible. The micromechanical environmental barrier structure 220 may comprise vertically extending rib structures 221 that may extend through the material layer 210 and penetrate into the substrate 200, as shown in Figure 4B. The rib structures 210 may be arranged in a cross-wise manner thereby creating a mesh structure.

The micromechanical environmental barrier structure 220 may be fabricated using wafer-level front-end processing. A main layer of the micromechanical environmental barrier structure 220 may comprise various materials used in front-end semiconductor processing, which include but are not limited to silicon, nitride, stacked silicon/nitride, and polymeric materials, e.g., polyimide, poly(methyl methacrylate) (PMMA), polydimethylsiloxane (PDMS), SU-8, and benzocyclobutene (BCB). The micromechanical environmental barrier structure 220 may be rigid and may provide sufficient large hole openings (e.g., 10 µm to 40 µm) to avoid high loss of signal-to-noise ratio (SNR) and sensitivity.

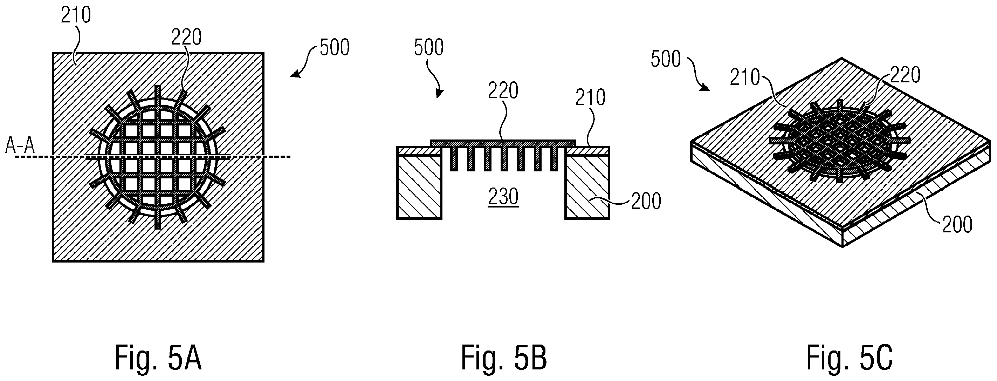

Figures 5A to 5C show a further method step. An anisotropic etching process, e.g. Reactive Ion Etching (RIE) using a Bosch etching process, is applied comprising at least one etching step for anisotropically etching from the second surface 202 towards the first surface 201 of the substrate 200 so as to create at least a first cavity 230 underneath (i.e. opposite to) the micromechanical environmental barrier structure 220. The cavity 230 may extend completely through the substrate 200. Therefore, the cavity 230 may also be referred to as an opening or a through hole.

As mentioned above, the material layer 210 may serve as an etch stop layer. According to the invention, the substrate 200 is etched until the etchant reaches the material layer 210. Even though not explicitly shown in Figures 5A to 5C, some of the material layer 210 may remain underneath the micromechanical environmental barrier structure 220, i.e. it may remain between the micromechanical environmental barrier structure 220 and the cavity 230.

Figures 5A to 5C show a method step, in which the material layer 210 underneath the micromechanical environmental barrier structure 220 was already removed such that the micromechanical environmental barrier structure 220 is already exposed. However, in some embodiments only those portions of the material layer 210 being located underneath the micromechanical environmental barrier structure 220 may be removed, as shown in Figures 5A to 5C, while the rest of the deposited material layer 210 may remain on the first surface 201 of the substrate 200.

After removal of the material layer 210 underneath the micromechanical environmental barrier structure 220, as shown in Figure 5B, the micromechanical environmental barrier structure 220 is exposed, i.e. it is in direct fluid contact with the cavity 230. Accordingly, fluids, and in particular gaseous fluids like ambient air, may flow through the cavity 230 and pass the micromechanical environmental barrier structure 220.

The micromechanical environmental barrier structure 220 may be configured to let a predetermined amount of air pass while preventing a predetermined amount of at least one of moisture, liquids, oil and solid environmental particles from passing.

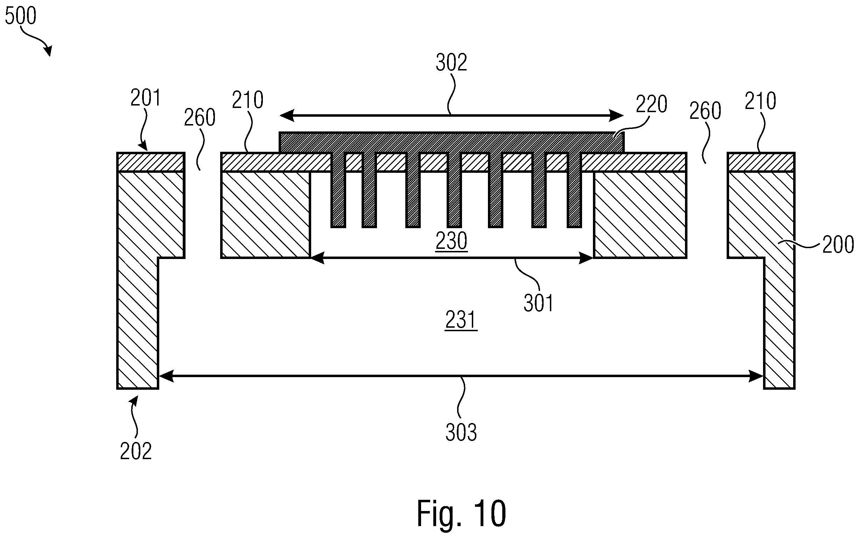

Figure 5C shows the resulting device, namely a micromechanical environmental barrier chip 500 comprising an air permeable microstructured micromechanical environmental barrier structure 220 suspended over a through hole or cavity 230 formed in a substrate 200. As will be explained in more detail below, the herein described innovative method allows for a very thin micromechanical environmental barrier chip 500. Details shall be described somewhat later with reference to Figures 10 to 13.

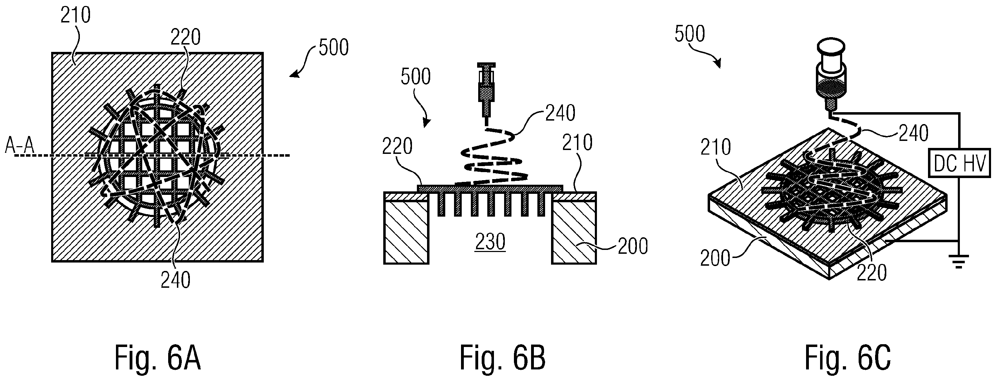

Meanwhile, reference shall be made to Figures 6A to 6C showing further method steps. Nanofibers 240 are deposited on the fabricated micromechanical environmental barrier chip 500, and in particular on the environmental barrier structure 220. The nanofibers 240 may consist of, or may comprise, different polymers, e.g., polyvinylidene fluoride (PVDF), polyacrylonitrile (PAN), polyvinyl chloride (PVC), polytetrafluoroethylene (PTFE), polyethylene (PE), and polyaniline (PANI).

The nanofibers 240 may be deposited by using electrospinning techniques. Various electrospinning methods can be opted, including needleless electrospinning, multi-jet electrospinning, cylindrical porous hollow tube electrospinning, bubble electrospinning, coaxial electrospinning, melt electrospinning, force-spinning, flash-spinning, self-bundling electrospinning, nanospider electrospinning, and charge injection electrospinning.

For example, electrospun nanofibers 240 may possess superhydrophobic characteristics and may provide a self-cleaning effect (lotus effect). Surface chemistry modification by organic self-assembled monolayers (SAMs), stearic acid-based modifiers, and nanoparticles (e.g., Ag, SiO₂, and TiO₂) can be carried out to further lower the surface energy of the roughened nanofiber surfaces resulting in improved hydrophobicity. The SAMs may consist of or comprise fluoroalkylsilanes (FAS), perfluorodecyltrichlorosilane (FDTS), and methyltrimethoxysilane (MTMS).

Accordingly, embodiments of the herein described innovative method may comprise a step of applying a surface chemistry modification to the applied nanofibers 240 by depositing at least one of
- organic self-assembled monolayers,
- stearic acid-based modifiers, and
- nanoparticles
onto the nanofibers 240 for lowering the surface energy of the nanofibers 240 resulting in an increased hydrophobicity.

Besides the above mentioned exemplary components, the organic self-assembled monolayers may comprise, or may consist of, at least one of:
- Perfluorodecyltrichlorosilane (FDTS),
- Heptadecafluoro-1,1,2,2-tetrahydrodecyltrichlorosilane (HDFS),
- Tridecafluoro-1,1,2,2-tetrahydrooctyltrichlorosilane (FOTS),
- Octadecyltrichlorsilane (ODTS),
- Methyltrimethoxysilane (MTMS),
- Bis(trimethylsilyl)amine or hexamethyldisilazane (HMDS),
- (3-Aminopropyl)triethoxysilane (APTES),
- Dichlorodimethylsilane (DDMS),
- Octadecyltrimethoxysilane (OTMS),
- Ethyltriethoxysilane (ETES), and
- 1H,1H,2H,2H-perfluorooctyltriethoxysilane (HFOTES).

As mentioned above, the innovative micromechanical environmental barrier chip 500 may be used with micromechanical MEMS-based acoustic components, like MEMS microphones, MEMS speaker or the like. To maintain a high SNR (Signal-to-Noise Ratio) of said MEMS-based acoustic components, and at the same time to provide a good environmental robustness towards particles and water, only a thin layer of nanofibers 240 may be deposited allowing high airflow through the holes or pores of the micromechanical environmental barrier structure 220.

To improve the adhesion between the applied nanofibers 240 and the micromechanical environmental barrier structure 220, several strategies can be applied, e.g. insertion of an adhesion promoter as a middle layer between the applied nanofibers 240 and the micromechanical environmental barrier structure 220, increasing the surface roughness of the micromechanical environmental barrier structure 220, or a three-dimensional (3D) modification of the micromechanical environmental barrier structure 220.

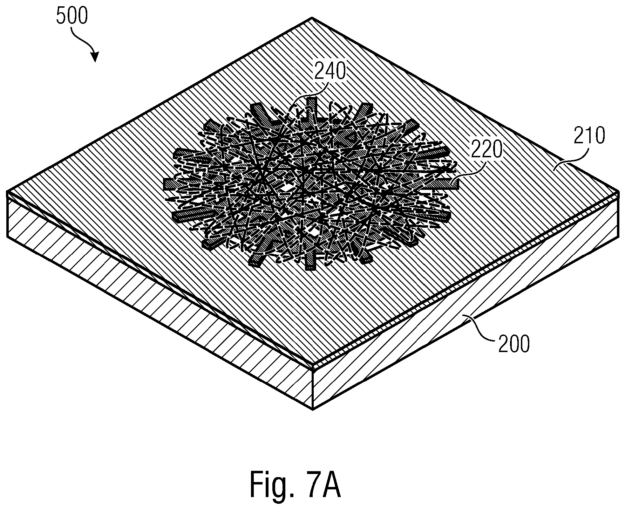

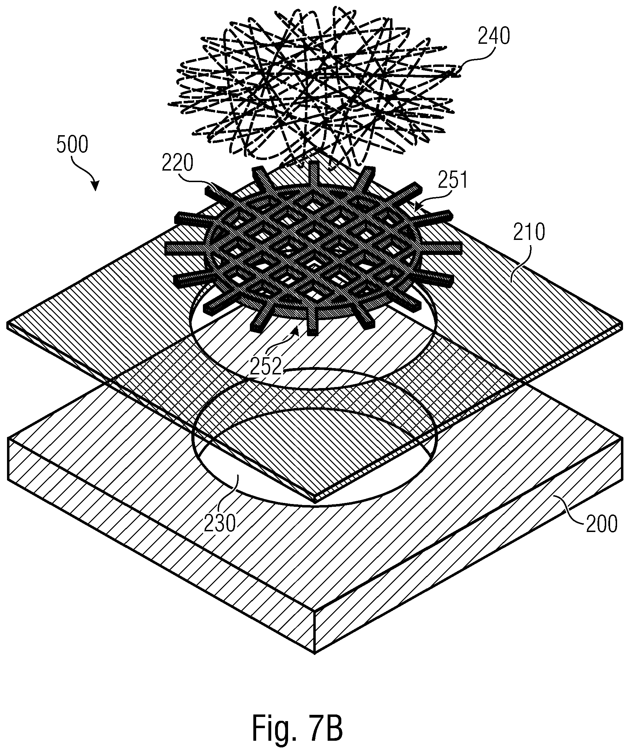

As shown in Figures 7A and 7B, the nanofibers 240 are applied onto the micromechanical environmental barrier structure 220 such that the nanofibers 240 combine to form an air permeable nanofibrous membrane structure. Therefore, the nanofibers 240 can support the environmental barrier structure 220 in its functionality, i.e. to let a predetermined amount of air pass while preventing a predetermined amount of at least one of moisture, liquids, oil and solid environmental particles from passing.

The nanofibers 240 may be applied on either one of a first side 251 (top) or a second side 252 (bottom) of the micromechanical environmental barrier structure 220. Alternatively, the nanofibers 240 may be applied on both the first and second sides 251, 252 (top and bottom) of the micromechanical environmental barrier structure 220.

Accordingly, the innovative method allows to manufacture a MEMS-based mesh chip 500 integrated with a nanofiber membrane 240. As shown in Figure 7B, the micromechanical environmental barrier chip 500 comprises a substrate 200 (e.g. a silicon substrate), having a through hole 230 formed therein. The through hole 230 extends between the first substrate surface 201 and the opposite second substrate surface 202 completely through the substrate 200. An additional material layer 210 (e.g. an etch stop layer comprising TEOS) is deposited at the first substrate surface 201. In the final device 500, the through hole 230 does also extend through this material layer 210. A micromechanical environmental barrier structure 220 (e.g. a MEMS-based mesh or membrane) is arranged at the first substrate surface 201, in particular at the additional material layer 210. The micromechanical environmental barrier structure 220 is suspended over the through hole 230. Nanofibers 240 are applied onto the micromechanical environmental barrier structure 220, e.g. by means of electrospinning techniques. The applied nanofibers 240 combine to form a nanofibrous mat or a nanofiber membrane.

Some materials used for the fabrication of nanofibers 240 (e.g. some polymers) may comprise less optimal adhesion characteristics for adhering the nanofibers 240 to the environmental barrier structure 220 and/or to the substrate 200. This may be an issue if an air flow with high air pressure passes through the MEMS-based mesh chip 500. If the nanofibers 240 are not properly fixed to the environmental barrier structure 220, then they may be swept away. To keep the nanofibers 240 stable on their position after deposition (i.e., to increase the stability of the nanofibers 240 at higher air pressure), one or more additional layers having a geometrical shape comprising, for instance, a frame or a ring structure, may optionally be applied on top of the nanofibers 240. Hence, this optional additional layer(s) (e.g., metal) can hold or fix the nanofibers 240.

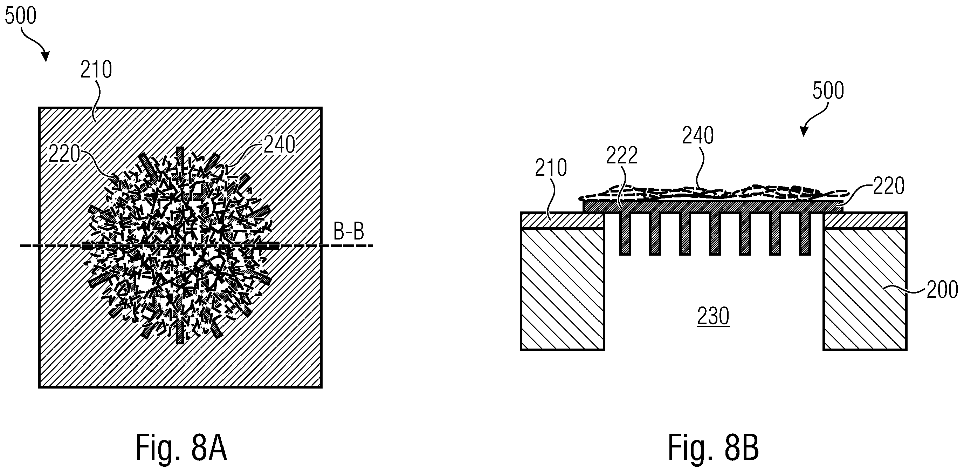

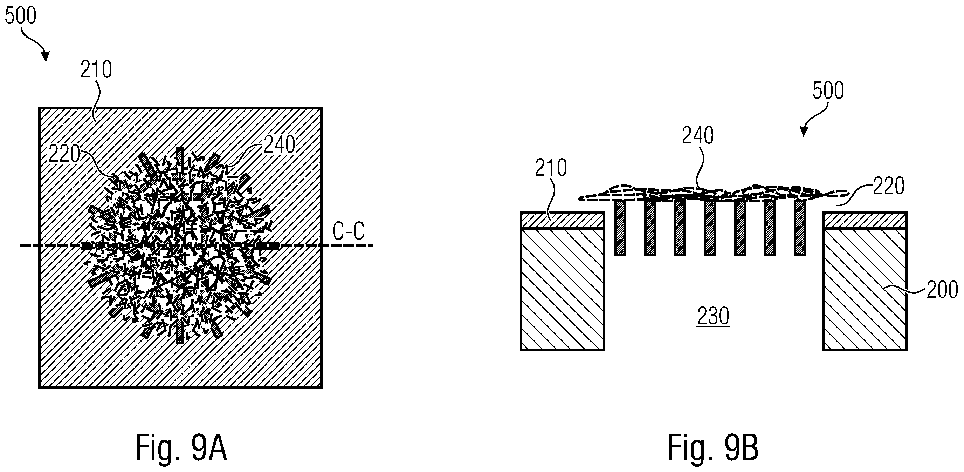

Figures 8A to 9B show some possible implementations and exemplary embodiments of an environmental barrier chip 500 with an integrated environmental barrier structure 220 and an additional nanofiber membrane 240. Figure 8B shows a cross-sectional view across the sectional line B-B shown in Figure 8A. Figure 9B shows a cross-sectional view across the sectional line C-C shown in Figure 9A. As can be seen, the nanofibers 240 may be applied randomly crosswise over the environmental barrier structure 220. The nanofibers 240 may be applied in multiple passes creating a nanofiber structure (e.g. membrane or mat) comprising multiple layers of stacked nanofibers 240 being arranged one atop the other, as shown in Figures 8B and 9B. The nanofibers 240 may extend over the horizontal ribs 222 (Fig. 8B) which form the mesh of the environmental barrier structure 220, and the nanofibers 240 may extend over the holes between the horizontal ribs 222 (Fig. 9B).

The whole process as described herein may be performed at wafer-level, wherein the substrate 200 may be a wafer from which a plurality of the above described micromechanical environmental barrier chips 500 can be produced. In this regard, the innovative method may further comprise a step of singulating (e.g., by dicing) said plurality of micromechanical environmental barrier chips 500 from the wafer.

For facilitating the singulation process and enabling a pick-and-place joining method of the innovative environmental barrier chip 500 onto a printed circuit board (PCB) used in acoustic component packaging (e.g., for MEMS microphone packages), an innovative device separation concept will be described herein by introducing thin microplates or microbeams between the single environmental barrier chips 500.

A non-limiting embodiment is depicted in Figure 10. Even though not explicitly shown here, the nanofibers 240 may be arranged on top of the environmental barrier structure 220 and the material layer 210 underneath the environmental barrier structure 220 may be removed, as discussed above. The above described cavity 230 is shown, which will be referred to as a first cavity in the following. Said first cavity 230 may comprise a lateral extension 301 that is equal to or smaller than the outer contour 302 (e.g. outer diameter) of the micromechanical environmental barrier structure 220. As indicated by arrows 301, 302, 303, the lateral extension is to be measured in-plane of the chip 500, i.e. orthogonally to the substrate thickness between the first and second substrate surfaces 201, 202.

In this embodiment, the step of applying the anisotropic etching process may further comprise an anisotropic etching step for anisotropically etching from the second substrate surface 202 towards the first substrate surface 201 so as to create a second cavity 231 in the substrate 200. The second cavity 231 may comprise a larger lateral extension 303 than the first cavity 230.

The step of applying the anisotropic etching process may comprise a further anisotropic etching step for anisotropically etching a plurality of discontinuous trenches 260 into the substrate 200, and optionally also into the material layer 210. The plurality of discontinuous trenches 260 may vertically extend between the first substrate surface 201 and the second cavity 231. Additionally or alternatively, the plurality of discontinuous trenches 260 may laterally surround the micromechanical environmental barrier structure 220.

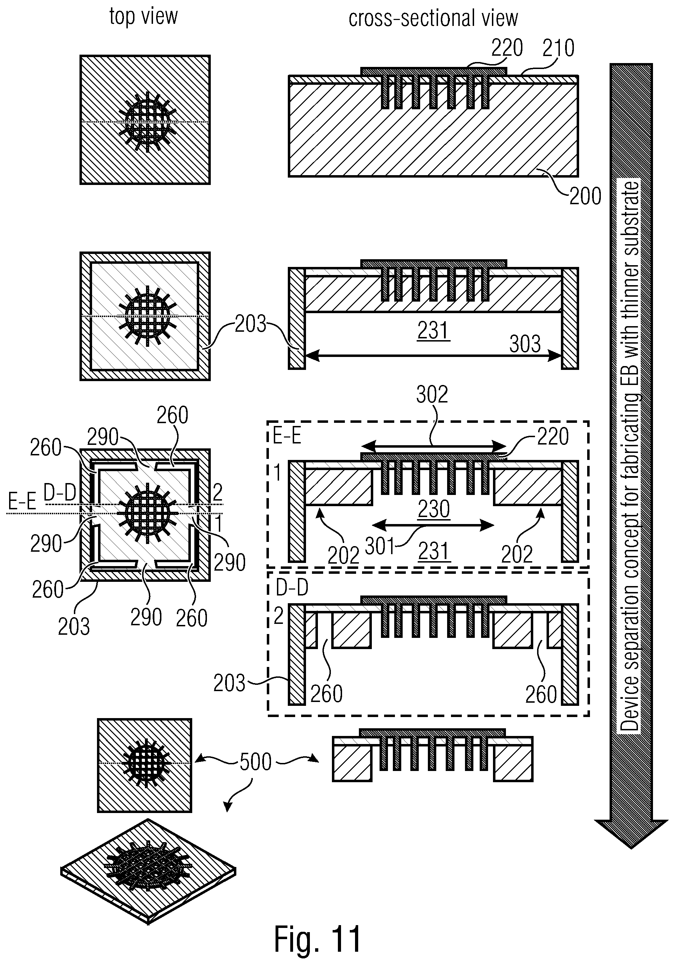

The term 'discontinuous' here means that the trenches 260 are not completely formed all around the environmental barrier structure 220, i.e., they are not fully surrounding the environmental barrier structure 220. Instead, some portions of substrate material may be left in between, such that the trenches 260 are separated from each other. These remaining portions of substrate material will form microbeams that hold the environmental barrier chip 500 on the substrate 200 prior to singulating it (e.g., by dicing). This shall be further explained with reference to Figure 11.

Figure 11 shows, from top to bottom, method steps for creating the above mentioned micro beams. The left hand side shows top views of the environmental barrier chip 500, while cross sectional views are shown on the right.

Starting from the uppermost picture row, the unprocessed substrate 200 is shown. The additional material layer 210 (e.g. TEOS) is deposited at the first substrate surface 201, and the environmental barrier structure 220 is arranged on top of the material layer 210. The uppermost picture row shows the fabrication of the micromechanical environmental barrier structure 220 by processing a main layer using surface MEMS micromachining methods. Here, the environmental barrier structure 220 may be created as either a mesh or a membrane. In this figure, a mesh is shown as an example. According to the innovative concept, nanofibers are applied onto the environmental barrier structure 220. In case of a membrane, there is no grid created. Instead, small ventholes may be provided to enable airflow coming from the package sound port.

The second picture row (from top) shows a method step of applying the anisotropic etching process which may comprise applying an anisotropic etching step, e.g. Reactive Ion Etching (RIE) using a Bosch etching process, for anisotropically etching a cavity 231 into the substrate 200. This cavity 231 may correspond to the above described second cavity 231. As indicated by means of cross-hatched lines, the lateral / circumferential remaining portions 203 of the substrate 200, where the second cavity 231 was not formed, may be thicker (thickness measured between first (top) surface and second (bottom) surface of the unprocessed substrate 200 in the uppermost picture row) than the rest of the substrate 200, where the second cavity 231 was formed. In other words, the substrate 200 is thinned in an area, where the cavity 231 is formed. The second cavity 231 may comprise a larger lateral extension 303 than the first cavity 230, that may be formed in a next method step.

Therefore, it shall be referred to the third and fourth picture row (from top). The third picture row shows a top view of the environmental barrier chip 500 on the left, and a cross-sectional view along the cross sectional line E-E on the right. The fourth picture row shows a cross-sectional view along the cross sectional line D-D.

As can be seen in the third picture row (from top), a further cavity 230 is etched into the substrate 200 by applying an anisotropic etching step, e.g. Reactive Ion Etching (RIE) using a Bosch etching process. This further cavity 230 may correspond to the above described first cavity 230 that is etched from the second substrate surface 202 up to the material layer 210, e.g. TEOS as an etch stop layer. Since the substrate 200 is thinned in this area, as mentioned above, the second substrate surface 202 may be the substrate surface of the thinned substrate 200, as shown in the picture. That is, the first cavity 230 may be etched into the thinned substrate 200, from the second surface 202 of the thinned substrate 200 up to the material layer 210. The first cavity 230 may comprise a lateral extension 301 that is equal to or smaller than the outer contour 302 (e.g., outer diameter) of the micromechanical environmental barrier structure 220.

As can further be seen in the third and fourth picture rows (from top), the anisotropic etching process may further comprise a step of anisotropically etching a plurality of discontinuous trenches 260 into the thinned substrate 200. This step may be performed at the same time as the above described step of creating the first cavity 230, i.e., the first cavity 230 and the discontinuous trenches 260 may be created in one and the same step of the anisotropic etching process. As can best be seen in the fourth picture row, the plurality of discontinuous trenches 260 may vertically extend between the first substrate surface 201 and the second cavity 231. That is, the discontinuous trenches 260 may be etched into the thinned portions of the substrate 200. As can best be seen in the top view of the third picture row, the plurality of discontinuous trenches 260 may laterally surround the micromechanical environmental barrier structure 220.

As mentioned above, the term 'discontinuous' here means that the trenches 260 are not completely formed all around the environmental barrier structure 220, i.e. they are not fully surrounding the environmental barrier structure 220. Instead, some portions of substrate material 290 may be left in between, such that the trenches 260 are separated from each other. These remaining portions 290 of substrate material will form micro beams 290 that hold the environmental barrier chip 500 on the substrate 200 prior to singulating it, e.g. by dicing.

Accordingly, the step of etching the plurality of discontinuous trenches 260 may comprise a step of leaving portions 290 of substrate material (optionally with the material layer 210 on top) inside the plurality of discontinuous trenches 260, such that these portions 290 form micro beams 290 which structurally connect the micromechanical environmental barrier chip 500 on one side of the plurality of discontinuous trenches 260 with the substrate 200 (e.g., a wafer) on an opposite other side of the plurality of discontinuous trenches 260.

Since the micro beams 290 are formed in the thinned substrate 200, the micro beams 290 may comprise the same thickness as the thinned substrate 200. Accordingly, the remaining thicker lateral/circumferential portions 203 (cross-hatched lines) of the substrate 200 may provide a frame structure at which the thinned substrate 200 may be suspended by means of the micro beams 290. Since the micro beams 290 may comprise the same thickness as the thinned substrate 200, the micro beams 290 can easily be broken / ruptured in order to singulate a single environmental barrier chip 500 from the substrate 200 during a pick-and-place process, in particular in case the substrate 200 is provided as a wafer. The last picture row (from top) shows a singulated environmental barrier chip 500.

Accordingly, the plurality of discontinuous trenches 260 may define the lateral size of the final singulated micromechanical environmental barrier chip 500. In other words, the above described etching steps may deem to define the final chip size after singulating the chip 500, as well as to create the thin micro beams 290 for separating the environmental barrier chip 500. The separation of the environmental barrier chip 500 from the wafer 200 may be done by using pick-and-place joining techniques. As a final device, a MEMS environmental barrier chip 500 on a thinned substrate 200 can be realized.

To create the thinned mechanical supporting substrate 200, a double Bosch etching process may be applied for creating the above described first and second cavities 230, 231. This method may be beneficial to avoid high SNR loss affected by a reduced back volume inside a lid of a MEMS microphone system, for example. A typical thickness of an initial unprocessed substrate 200, that may be used to create an environmental barrier structure 220 as described herein, may be between 200 µm and 500 µm, and preferably between 300 µm and 400 µm. Using anisotropic etching, e.g. a double Bosch etching process, the final environmental barrier chip 500 may comprise a thickness (i.e. height) between 20 µm and 150 µm, and preferably between 30 µm and 60 µm, depending on the used reactive ion etching (RIE) process parameters, especially the etching duration.

Accordingly, the unprocessed initial substrate 200 (prior to applying the anisotropic etching process) may comprise a thickness between 200 µm and 500 µm. By applying the anisotropic etching process, the second cavity 231 may be formed such that a thinned remaining portion of the substrate 200 results that comprises a thickness between 20 µm to 150 µm and which defines the final thickness of the environmental barrier chip 500.

Even though not explicitly shown in Figure 11, the nanofibers 240 may be arranged on top of the environmental barrier structure 220 and any of the material layer 210 underneath the environmental barrier structure 220 may be removed, as discussed above. Furthermore, the etching steps for forming the first and second cavities 230, 231, respectively, may be swapped regarding their temporal execution, i.e. the smaller first cavity 230 may be created first, before creating the larger second cavity 231 afterwards.

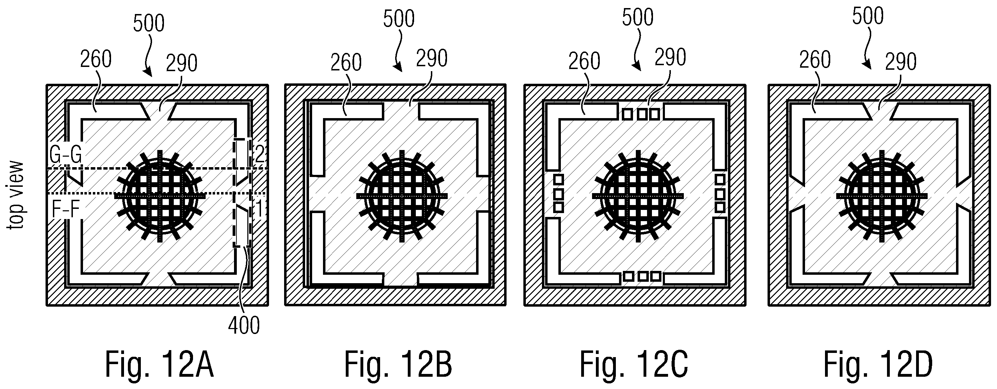

As shown in Figures 12A to 12F, various designs of micro beams 290 may be created resulting in optimized device breaking performance during the pick-and-place process. These may include but are not limited to rectangular micro beams 290 (Figure 12B), trapezoidal beams (Figure 12A), round-edged trapezoidal micro beams 290 (Figure 12D), and perforation-integrated beams (Figure 12C). In case of trapezoidal micro beams, the smaller region is located at the inner part close to the active area of the membrane.

In the non-limiting examples shown in Figures 12A to 12F, the micro beams 290 are located approximately in the center of each of the four lateral sides of the environmental barrier chip 500. Additionally or alternatively, one or more micro beams 290 may be located at different positions, e.g., at one or more corner regions of the environmental barrier chip 500.

Accordingly, the micro beams 290 may comprise at least one of the following geometrical shapes:
- a trapezoidal shape,
- a rectangular shape,
- a round-edged trapezoidal shape, and
- a geometrical shape comprising one or more perforations.

Summarizing, Figures 12A to 12D show different designs of micro beams 290 for breaking the device 500 from the wafer 200. The micro beams 290 may be created in various shapes to optimize the separation process.

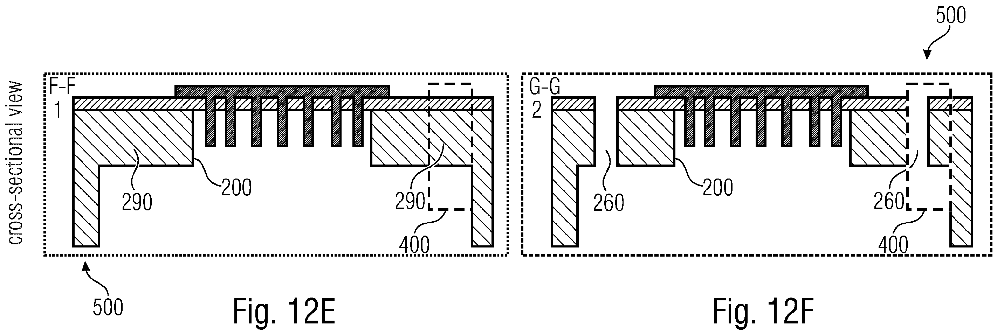

Figure 12E shows a cross-sectional view along line F-F in Figure 12A. Figure 12F shows a cross-sectional view along line G-G in Figure 12A. The rectangle 400 drawn in dashed lines marks the micro beams 290 (Figure 12E) and the trenches 260 (Figure 12F), respectively, in the thinned substrate 200.

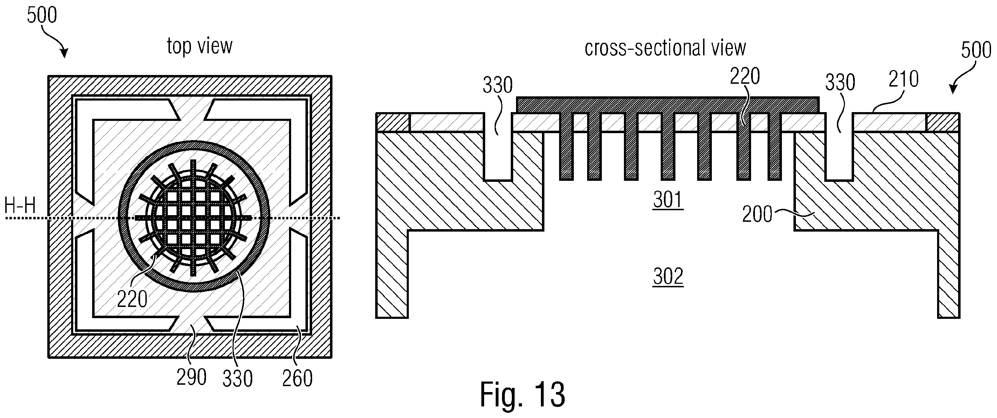

Figure 13 shows a further embodiment of an environmental barrier chip 500, wherein a top view of the environmental barrier chip 500 is shown on the left side, while a cross-sectional view of the environmental barrier chip 500 along the cross-section line H-H is depicted on the right. Though not depicted here, the nanofibers 240 are arranged on top of the environmental barrier structure 220.

Additional stopping structures 330 (e.g., microwalls or microtrenches) may be created on the edge of the mechanical supporting substrate 200 to avoid adhesive (glue) to reach the environmental barrier structure 220, e.g., an active membrane area, during the joining process. Said additional stopping structures 330 may be provided as a continuous trench, as exemplarily depicted.

According to an embodiment, the innovative method may comprise a step of etching a continuous trench 330 into the substrate 220 (and optionally into the material layer 210). As can best be seen in the top view, the continuous trench 330 may laterally surround the micromechanical environmental barrier structure 220. Alternatively, the trench 330 may be discontinuous. The trench 330 may preferably comprise a circular shape, while other geometrical shapes may be possible.

Even though the stopping structure 330 is depicted in combination with the above discussed micro beams 290, the stopping structure 330 for trapping the adhesive may also be provided in each of the other embodiments that may not necessarily comprise the micro beams 290 and/or the discontinuous trenches 260.

However, in case the micro beams 290 and/or discontinuous trenches 260 are available, then the stopping structure 330 (e.g. trench) may be located laterally between the micromechanical environmental barrier structure 220 and the micro beams 290, as shown in the top view of Figure 13. The stopping structure 330 may comprise a circular shape.

Accordingly, the method may comprise creating a circular trench 330 for stopping the bleeding of any applied adhesive (e.g., glue, solder paste, or the like) during a joining process between the environmental barrier chip 500 and a further acoustic component, such as a MEMS microphone chip. This protecting trench concept is an additional optional feature for the joining technique that involves the environmental barrier chip 500 placed inside a lid of a sound component package, such as a MEMS microphone package, in particular if the environmental barrier chip 500 may be placed underneath the MEMS microphone chip.

As mentioned above, the whole process as described herein may be performed at wafer-level, wherein the substrate 200 may be a wafer from which a plurality of the above described micromechanical environmental barrier chips 500 may be singulated. In this regard, the innovative method may further comprise a step of singulating (e.g. by dicing) said plurality of micromechanical environmental barrier chips 500 from the wafer 200. For example, the micromechanical environmental barrier chips 500 may be fabricated using wafer-level front-end processing. Accordingly, the innovative micromechanical environmental barrier chip 500 may be integrated to the frontend chip, instead of manufacturing environmental barriers as individual devices. In result, it becomes possible to provide an acoustic component (e.g. a MEMS-microphone) with an integrated environmental barrier chip 500 directly in one and the same package. This may provide for a low-cost packaging solution for microphones with higher robustness against ingress of environmental solid, gaseous and/or moist particles.

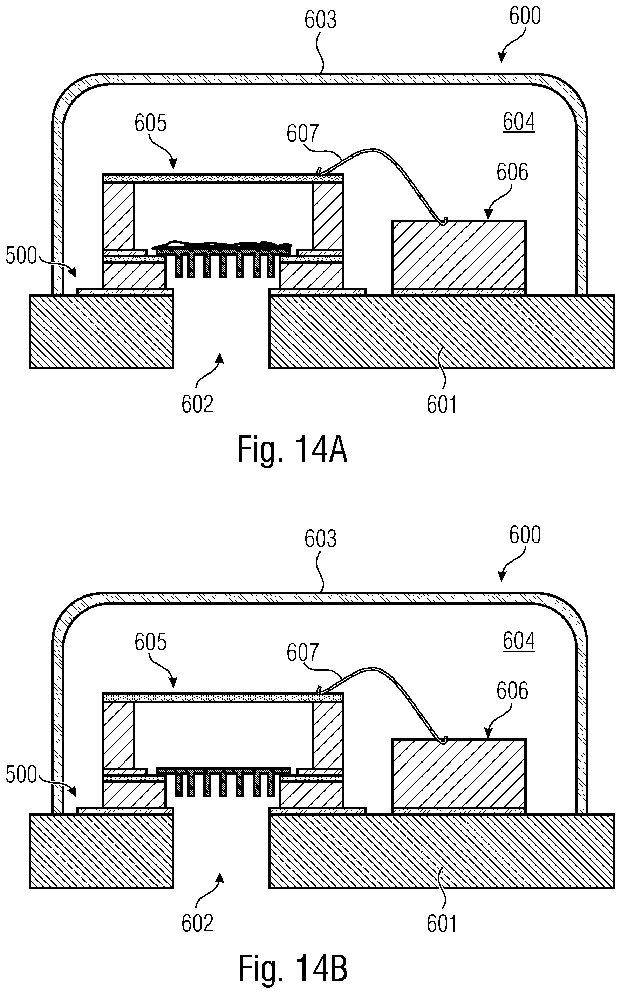

Furthermore, the above described versatile device separation concept (by means of micro beams 290) may be applied not only for passive environmental barrier structures 220 (e.g. membrane, mesh, nanofiber membrane-integrated mesh chips), but also for active MEMS devices like microphones, pressure sensors, and others. The created environmental barrier chip 500 based on this separation method can be mounted into a microphone package in different architectures, as will be explained in more detail with reference to Figures 14A to 14E. The created environmental barrier chip 500 may comprise a single environmental barrier structure 220 (e.g., environmental barrier mesh only, environmental barrier membrane only, or environmental barrier nanofibers only) or joint environmental barrier elements (e.g. a nanofiber membrane-integrated mesh chip or environmental barrier membrane-stacked environmental barrier mesh chip).

Figures 14A to 14E show some non-limiting examples of packaging concepts for the micromechanical environmental barrier chip 500 according to the herein described innovative principle. The package 600 may comprise a carrier substrate 601, e.g. a PCB, comprising a sound port opening 602. The package 600 may further comprise a cover or lid 603 being arranged on the substrate 601. The lid 603 provides a cavity 604 inside of which different electrical and/or electronic components may be arranged.

In this non-limiting example, a MEMS microphone chip 605 may be arranged inside the cavity 604. Additionally, the herein described innovative micromechanical environmental barrier chip 500 may be arranged inside the cavity 604. Furthermore, a circuitry 606 may be arranged inside the cavity 604. The circuitry 606 may be provided as an integrated circuit (IC), for instance as an ASIC (Application Specific Integrated Circuit). The circuitry 606 may be electrically connected to the MEMS microphone chip 605, for example by means of bond wires 607.

As shown in Figures 14A to 14E, the environmental barrier chip 500 may be arranged directly opposite the sound port 602 such that the environmental barrier chip 500 is in direct fluid communication with the sound port 602. By means of the environmental barrier chip 500, environmental solid, gaseous and/or moist particles may be prevented from entering the cavity 604 of the package 600. The MEMS microphone chip 605 may be stacked directly atop the environmental barrier chip 500. Thus, the environmental barrier chip 500 prevents environmental solid, gaseous and/or moist particles from reaching (and possibly destroying) the sensitive membrane of the MEMS microphone 605.

The environmental barrier chip 500 may be attached to the carrier substrate 601 by means of adhesive, e.g. glue. Additionally or alternatively, the MEMS microphone chip 605 may be attached to the environmental barrier chip 500 by means of an adhesive, e.g. glue.

Figure 14A shows an embodiment of a packaging concept in which the environmental barrier chip 500 comprises an environmental barrier structure 220 formed as a micro machined mesh, in combination with nanofibers 240, as described with reference to Figures 6A to 7A.

Figure 14A shows a nanofiber-integrated environmental barrier mesh chip 500 arranged inside the package 600.

Figure 14B shows an exemplary packaging concept in which the environmental barrier chip 500 comprises an environmental barrier structure 220 formed as a micro machined mesh without nanofibers, as described with reference to Figures 2A to 5C. Figure 14B shows an environmental barrier mesh chip 500 without nanofibers arranged inside the package 600.

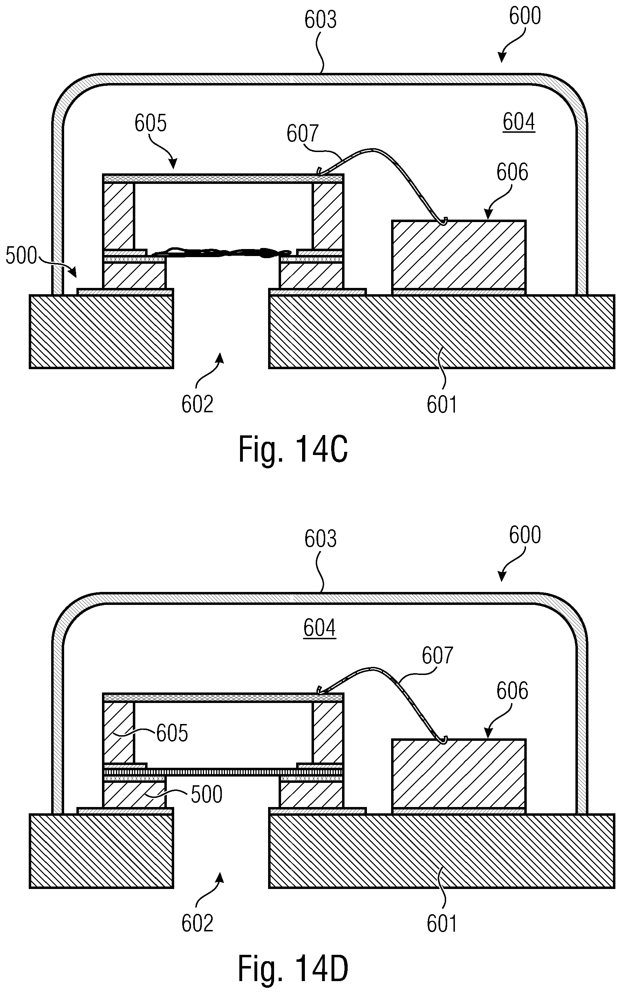

Figure 14C shows a further exemplary packaging concept in which the environmental barrier chip 500 comprises an environmental barrier structure 220 formed as a nanofibrous membrane or nanofibrous mat only, which may be fabricated from deposited nanofibers 240. Figure 14C shows an environmental barrier nanofiber membrane chip 500 arranged inside the package 600.

Figure 14D shows a further exemplary packaging concept in which the environmental barrier chip 500 comprises an environmental barrier structure 220 formed as a membrane. It is to be mentioned that each and every embodiment of the environmental barrier structure 220 according to the herein described innovative principle may be formed as a membrane instead of a micromachined mesh. The membrane 220 may be plane or structured with high compliance. According to the innovative concept, nanofibers are deposited thereon. Figure 14D shows an environmental barrier membrane chip 500 with a membrane made from material other than nanofibers arranged inside the package 600.

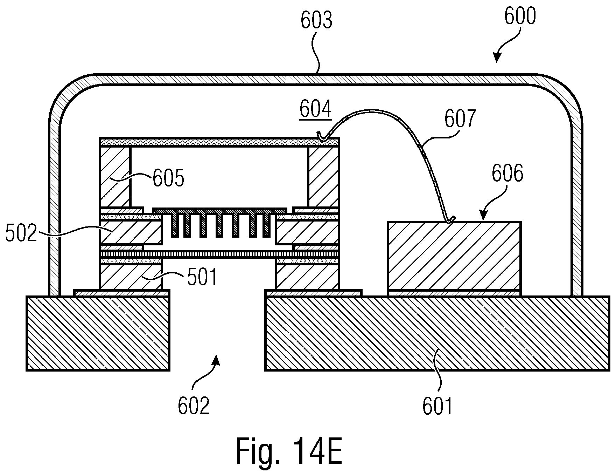

Figure 14E shows a further exemplary packaging concept in which two environmental barrier chips 501, 502 may be stacked one atop the other. A first environmental barrier chip 501 may comprise a microstructured mesh with nanofibers deposited thereon. A second environmental barrier chip 502 may comprise a membrane (with or without nanofibers deposited thereon). One of the first and second environmental barrier chips 501, 502 may be arranged on the carrier substrate 601 opposite the sound port 602. The other one of the first and second environmental barrier chips 501, 502 may be stacked atop the bottom one. The MEMS microphone chip 605 may be stacked atop the first and second environmental barrier chips 501, 502. Figure 14E shows a membrane-stacked mesh chip 500 arranged inside the package 600.

According to such an embodiment, the innovative method may further comprise a step of packaging the micromechanical environmental barrier chip 500 by mounting the micromechanical environmental barrier chip 500 together with a MEMS microphone chip 605 onto a carrier substrate 601, and arranging a package lid 603 on the carrier substrate 601, such that the package lid 603 covers and encloses the micromechanical environmental barrier chip 500 and the MEMS microphone chip 605.

According to a further embodiment, the micromechanical environmental barrier chip 500 may be directly attached to the carrier substrate 601, wherein the MEMS microphone chip 605 is directly attached on top of the micromechanical environmental barrier chip 500, thereby forming a chip stack in which the micromechanical environmental barrier chip 500 is positioned between the MEMS microphone chip 605 and the carrier substrate 601.

According to a further embodiment, the carrier substrate 601 may comprise a sound port opening 602, wherein the micromechanical environmental barrier chip 500 faces the sound port opening 602, such that the environmental barrier chip 500 is in fluid communication with the sound port opening 602.

According to a further embodiment, the micromechanical environmental barrier chip 500 and the MEMS microphone chip 605 may be provided as two separate discrete components.

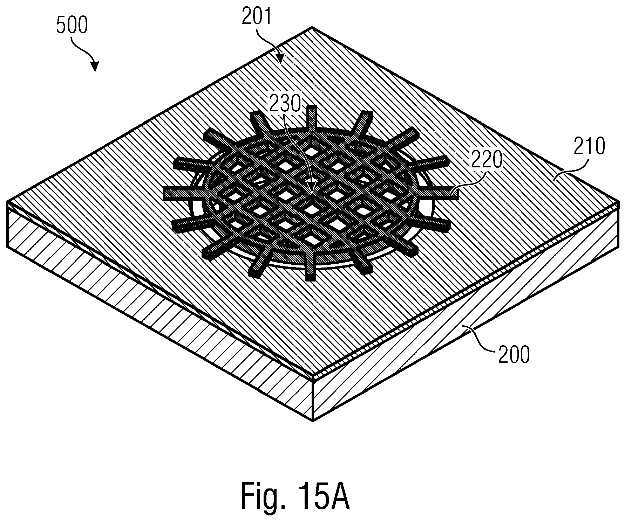

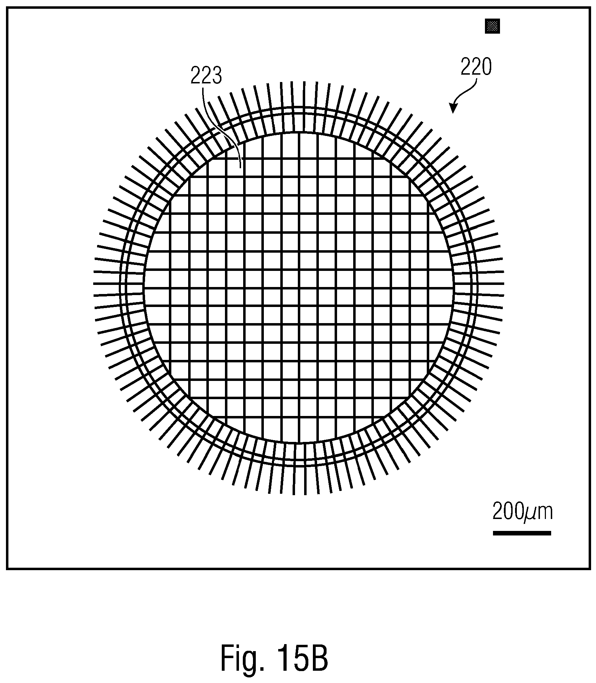

Tests and simulations were performed in order to verify the effectiveness of the environmental barrier chip 500. Figure 15A shows a schematic perspective view of an exemplary environmental barrier chip 500 with an environmental barrier structure 220 attached to the first substrate surface 201. Figure 15B shows a picture taken with a scanning electron microscope, said picture showing the upper surface (i.e. first substrate surface 201) of the environmental barrier chip 500, wherein the environmental barrier structure 220 is provided as a micromachined mesh with square grids 223. Each of the square grids 223 may comprise a square grid size of x µm (i.e. the length is x µm, and the width is also x µm).

The environmental barrier structure 220 is arranged above the first cavity 230. The cavity 230 may comprise a size of y µm. In case of a circular cavity 230, the size is defined as the diameter of the cavity 230.

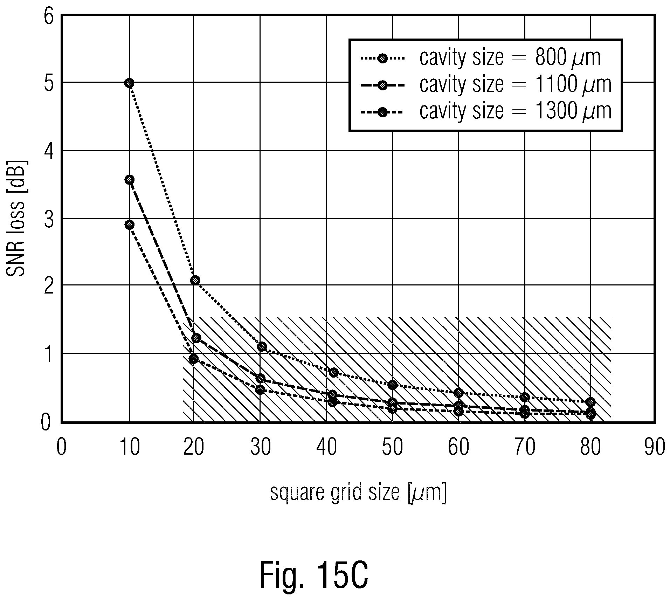

Figure 15C shows the correlation between the square grid size and the SNR loss in dB. The numbers are only for illustrating purposes and shall not be construed as being limiting in any way. As can be seen, the smaller the square grid size, the higher the SNR loss. In other words, a smaller grid size leads to a higher SNR loss. The grey shaded box shows an optimal range, indicating that a square grid size of 18 µm or more is desirable.

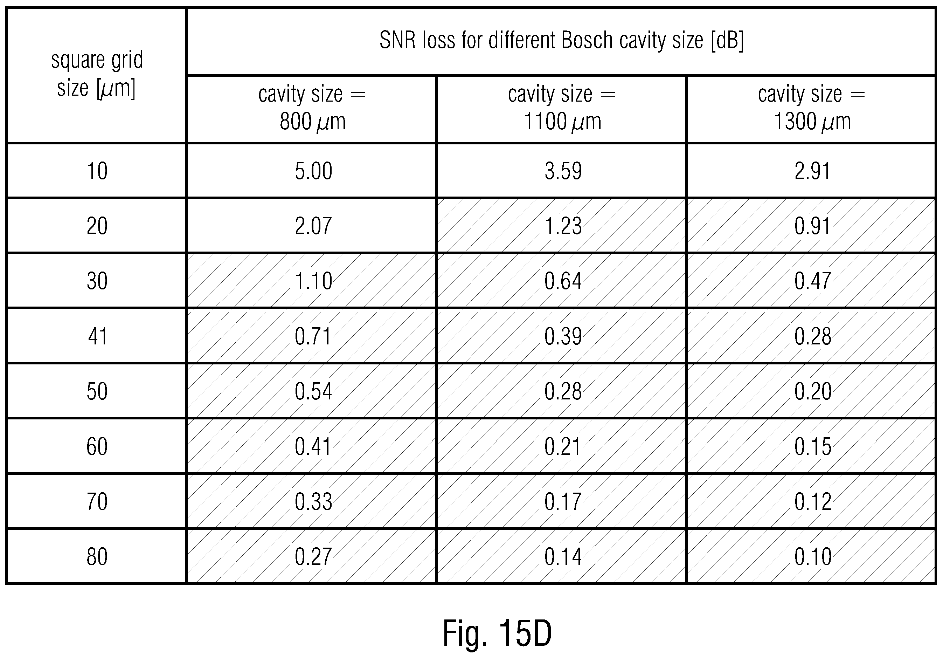

Figure 15D shows the correlation between the square grid size and the cavity size. The grey-shaded rows and columns indicate combinations that worked well. In other words, different cavity sizes resulted in similar trends with varied SNR loss values, in which a grid size of 10 µm can be excluded from the design because of too high SNR loss. Also a grid size of 20 µm in combination with a cavity size of 800 µm may be excluded.

Depending on the size of the cavity 230, the square grid size of an environmental barrier structure 220 shall be 20 µm or more in order to provide a good SNR while efficiently preventing environmental solid, gaseous and/or moist particles from passing the environmental barrier structure 220.

Summarizing, the herein described innovative concept provides for manufacturing and integration methods for MEMS-based environmental barriers 220. It further provides for a device separation concept for packaging purposes.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description.

## Claims

1. A method for manufacturing a micromechanical environmental barrier chip (500), the method comprising:
providing a substrate (200) having a first substrate surface (201) and an opposite second substrate surface (202),
depositing a material layer (210) onto the first substrate surface (201), the material layer (210) having a different etch characteristic than the substrate (200),
creating an air permeable microstructured micromechanical environmental barrier structure (220) on top of the material layer (210) by applying a microstructuring process,
applying an anisotropic etching process comprising at least one etching step for anisotropically etching through the substrate (200) until reaching the material layer (210) so as to create at least a first cavity (230) opposite the micromechanical environmental barrier structure (220),
removing the material layer (210) residing inside the cavity in order to expose the environmental barrier structure (220), and
applying nanofibers (240) onto the micromechanical environmental barrier structure (220), such that the nanofibers (240) combine to form an air permeable nanofibrous membrane structure.

2. The method according to claim 1,
wherein the nanofibers (240) are applied on either one of a first side (251) or a second side (252) of the micromechanical environmental barrier structure (220), or
wherein the nanofibers (240) are applied on both the first and second sides (251, 252) of the micromechanical environmental barrier structure (220).

3. The method according to claim 1 or 2,
wherein the step of applying the nanofibers (240) comprises at least one of:
• arranging an adhesion promotion layer between the nanofibers (240) and the micromechanical environmental barrier structure (220),
• increasing a surface roughness of the micromechanical environmental barrier structure (220), and
• applying a three-dimensional modification to the micromechanical environmental barrier structure (220),
for improving an adhesion between the nanofibers (240) and the micromechanical environmental barrier structure (220).

4. The method according to any one of the preceding claims,
further comprising a step of applying a surface chemistry modification to the applied nanofibers (240) by depositing at least one of
• organic self-assembled monolayers,
• stearic acid-based modifiers, and
• nanoparticles
onto the nanofibers (240) for lowering the surface energy of the nanofibers (240) resulting in an increased hydrophobicity.

5. The method according to claim 4,
wherein the organic self-assembled monolayers comprise or consist of at least one of:
• Perfluorodecyltrichlorosilane (FDTS),
• Heptadecafluoro-1,1,2,2-tetrahydrodecyltrichlorosilane (HDFS),
• Tridecafluoro-1,1,2,2-tetrahydrooctyltrichlorosilane (FOTS),
• Octadecyltrichlorsilane (ODTS),
• Methyltrimethoxysilane (MTMS),
• Bis(trimethylsilyl)amine or hexamethyldisilazane (HMDS),
• (3-Aminopropyl)triethoxysilane (APTES),
• Dichlorodimethylsilane (DDMS),
• Octadecyltrimethoxysilane (OTMS),
• Ethyltriethoxysilane (ETES), and
• 1H,1H,2H,2H-perfluorooctyltriethoxysilane (HFOTES).

6. The method according to any one of the preceding claims,
wherein the micromechanical environmental barrier structure (220) is formed as a perforated air permeable membrane, or
wherein the micromechanical environmental barrier structure (220) is formed as an air permeable mesh.

7. The method according to any one of the preceding claims,
wherein the micromechanical environmental barrier structure (220) is configured to let a predetermined amount of air pass while preventing a predetermined amount of at least one of moisture, liquids, oil and solid environmental particles from passing.

8. The method according to any one of the preceding claims,
wherein the method is performed at wafer-level, wherein the substrate (200) is a wafer from which a plurality of micromechanical environmental barrier chips (500) can be produced, and
wherein the method further comprises a step of singulating said plurality of micromechanical environmental barrier chips (500) from said wafer (200).

9. The method according to any one of the preceding claims,
wherein the first cavity (230) comprises a lateral extension (301) that is equal to or smaller than the outer contour (302) of the micromechanical environmental barrier structure (220),
wherein the step of applying the anisotropic etching process further comprises
applying an anisotropic etching step for anisotropically etching a second cavity (231) into the substrate (200), the second cavity (231) comprising a larger lateral extension (303) than the first cavity (230), and
applying a further anisotropic etching step for anisotropically etching a plurality of discontinuous trenches (260) into the substrate (200), the plurality of discontinuous trenches (260) laterally surrounding the micromechanical environmental barrier structure (220) and vertically extending between the first surface (201) of the substrate (200) and the second cavity (231).

10. The method according to claim 9,
wherein the plurality of discontinuous trenches (260) defines the lateral size of the micromechanical environmental barrier chip (500).

11. The method according to claim 9 or 10,
wherein the step of etching the plurality of discontinuous trenches (260) into the substrate (200) comprises a step of leaving portions (290) of substrate material between the plurality of discontinuous trenches (260), such that the left portions (290) form micro beams (290) which structurally connect the micromechanical environmental barrier chip (500) on one side of the plurality of discontinuous trenches (260) to the substrate (200) on an opposite other side of the plurality of discontinuous trenches (260).

12. The method according to claim 11,
further comprising a step of breaking the micro beams (290) for structurally disconnecting the micromechanical environmental barrier chip (500) from the substrate (200) thereby singulating the micromechanical environmental barrier chip (500).

13. The method according to claims 9 to 12,
wherein, prior to applying the anisotropic etching process, the substrate (200) comprises a thickness to be measured between the first and second surfaces (201, 202) of the substrate (200), said thickness is between 200 µm and 500 µm, and
wherein the second cavity (231) is formed, by applying the anisotropic etching process, such that a thinned portion of the substrate (200) remains that comprises a thickness between 20 µm to 150 µm and which defines the final thickness of the environmental barrier chip (500).

14. A micromechanical environmental barrier chip (500) manufactured by a method according to any one of the preceding claims.

## Patentansprüche

1. Verfahren zum Herstellen eines Mikromechanikumgebungsbarrierechips (500), wobei das Verfahren folgende Schritte aufweist:
Bereitstellen eines Substrats (200) mit einer ersten Substratoberfläche (201) und einer gegenüberliegenden zweiten Substratoberfläche (202),
Abscheiden einer Materialschicht (210) auf der ersten Substratoberfläche (201), wobei die Materialschicht (210) eine unterschiedliche Ätzcharakteristik als das Substrat (200) aufweist,
Erzeugen einer luftdurchlässigen mikrostrukturierten Mikromechanikumgebungsbarrierestruktur (220) auf der Materialschicht (210) durch Anwenden eines Mikrostrukturierungsprozesses,
Anwenden eines anisotropen Ätzprozesses, der mindestens einen Ätzschritt aufweist, zum anisotropen Ätzen durch das Substrat (200), bis die Materialschicht (210) erreicht ist, um mindestens einen ersten Hohlraum (230) gegenüber der Mikromechanikumgebungsbarrierestruktur (220) zu erzeugen,
Entfernen der Materialschicht (210), die sich innerhalb des Hohlraums befindet, um die Umgebungsbarrierestruktur (220) freizulegen, und
Aufbringen von Nanofasern (240) auf die Mikromechanikumgebungsbarrierestruktur (220), so dass sich die Nanofasern (240) verbinden, um eine luftdurchlässige Nanofasermembranstruktur zu bilden.

2. Verfahren gemäß Anspruch 1,
wobei die Nanofasern (240) entweder auf einer ersten Seite (251) oder einer zweiten Seite (252) der Mikromechanikumgebungsbarrierestruktur (220) aufgebracht werden, oder
wobei die Nanofasern (240) sowohl auf der ersten als auch der zweiten Seite (251, 252) der Mikromechanikumgebungsbarrierestruktur (220) aufgebracht werden.

3. Verfahren gemäß Anspruch 1 oder 2,
wobei der Schritt des Aufbringens der Nanofasern (240) mindestens einen der folgenden Schritte aufweist:
• Anordnen einer haftungsfördernden Schicht zwischen den Nanofasern (240) und der Mikromechanikumgebungsbarrierestruktur (220),
• Erhöhen einer Oberflächenrauheit der Mikromechanikumgebungsbarrierestruktur (220), und
• Anwenden einer dreidimensionalen Modifikation auf die Mikromechanikumgebungsbarrierestruktur (220),
um eine Haftung zwischen den Nanofasern (240) und der Mikromechanikumgebungsbarrierestruktur (220) zu verbessern.

4. Verfahren gemäß einem der vorhergehenden Ansprüche,
das ferner einen Schritt des Anwendens einer Oberflächenchemiemodifikation auf die aufgebrachten Nanofasern (240) durch Abscheiden von mindestens einem der folgenden aufweist:
• organischen selbstorganisierten Monoschichten,
• Stearinsäure-basierten Modifikatoren und
• Nanopartikeln
auf die Nanofasern (240) zum Senken der Oberflächenenergie der Nanofasern (240), was zu einer erhöhten Hydrophobizität führt.

5. Verfahren gemäß Anspruch 4,
wobei die organischen selbstorganisierten Monoschichten mindestens eines der folgenden aufweisen oder daraus bestehen:
• Perfluordecyltrichlorsilan (FDTS),
• Heptadecafluor-1,1,2,2-tetrahydrodecyltrichlorsilan (HDFS),
• Tridecafluor-1,1,2,2-tetrahydrooctyltrichlorsilan (FOTS),
• Octadecyltrichlorsilan (ODTS),
• Methyltrimethoxysilan (MTMS),
• Bis(trimethylsilyl)amin oder Hexamethyldisilazan (HMDS),
• (3-Aminopropyl)triethoxysilan (APTES),
• Dichlordimethylsilan (DDMS),
• Octadecyltrimethoxysilan (OTMS),
• Ethyltriethoxysilan (ETES) und
• 1H,1H,2H,2H-Perfluoroctyltriethoxysilan (HFOTES).

6. Verfahren gemäß einem der vorhergehenden Ansprüche,
wobei die Mikromechanikumgebungsbarrierestruktur (220) als eine perforierte luftdurchlässige Membran ausgebildet ist, oder
wobei die Mikromechanikumgebungsbarrierestruktur (220) als luftdurchlässige Maschen ausgebildet ist.

7. Verfahren gemäß einem der vorhergehenden Ansprüche,
wobei die Mikromechanikumgebungsbarrierestruktur (220) konfiguriert ist, um eine vorbestimmte Menge an Luft passieren zu lassen, während verhindert wird, dass eine vorbestimmte Menge von mindestens einem von Feuchtigkeit, Flüssigkeiten, Öl und festen Umgebungspartikeln passiert.

8. Verfahren gemäß einem der vorhergehenden Ansprüche,
wobei das Verfahren auf Waferebene durchgeführt wird, wobei das Substrat (200) ein Wafer ist, aus dem eine Mehrzahl von Mikromechanikumgebungsbarrierechips (500) hergestellt werden kann, und
wobei das Verfahren ferner einen Schritt des Vereinzelns der Mehrzahl von Mikromechanikumgebungsbarrierechips (500) von dem Wafer (200) aufweist.

9. Verfahren gemäß einem der vorhergehenden Ansprüche,
wobei der erste Hohlraum (230) eine laterale Ausdehnung (301) aufweist, die gleich oder kleiner als die äußere Kontur (302) der Mikromechanikumgebungsbarrierestruktur (220) ist,
wobei der Schritt des Anwendens des anisotropen Ätzprozesses ferner Folgendes aufweist:
Anwenden eines anisotropen Ätzschrittes zum anisotropen Ätzen eines zweiten Hohlraums (231) in das Substrat (200), wobei der zweite Hohlraum (231) eine größere laterale Ausdehnung (303) als der erste Hohlraum (230) aufweist, und
Anwenden eines weiteren anisotropen Ätzschrittes zum anisotropen Ätzen einer Mehrzahl von diskontinuierlichen Gräben (260) in das Substrat (200), wobei die Mehrzahl von diskontinuierlichen Gräben (260) die Mikromechanikumgebungsbarrierestruktur (220) lateral umgibt und sich vertikal zwischen der ersten Oberfläche (201) des Substrats (200) und dem zweiten Hohlraum (231) erstreckt.

10. Verfahren gemäß Anspruch 9,
wobei die Mehrzahl von diskontinuierlichen Gräben (260) die laterale Größe des Mikromechanikumgebungsbarrierechips (500) definiert.

11. Verfahren gemäß Anspruch 9 oder 10,
wobei der Schritt des Ätzens der Mehrzahl von diskontinuierlichen Gräben (260) in das Substrat (200) einen Schritt des Belassens von Abschnitten (290) von Substratmaterial zwischen der Mehrzahl von diskontinuierlichen Gräben (260) aufweist, so dass die linken Abschnitte (290) Mikrobalken (290) bilden, die den Mikromechanikumgebungsbarrierechip (500) auf einer Seite der Mehrzahl von diskontinuierlichen Gräben (260) mit dem Substrat (200) auf einer gegenüberliegenden anderen Seite der Mehrzahl von diskontinuierlichen Gräben (260) strukturell verbinden.

12. Verfahren gemäß Anspruch 11,
das ferner einen Schritt des Brechens der Mikrobalken (290) zum strukturellen Trennen des Mikromechanikumgebungsbarrierechips (500) von dem Substrat (200) aufweist, wodurch der Mikromechanikumgebungsbarrierechip (500) vereinzelt wird.

13. Verfahren gemäß den Ansprüchen 9 bis 12,
wobei vor dem Anwenden des anisotropen Ätzprozesses das Substrat (200) eine zu messende Dicke zwischen der ersten und der zweiten Oberfläche (201, 202) des Substrats (200) aufweist, wobei die Dicke zwischen 200 µm und 500 µm liegt, und
wobei der zweite Hohlraum (231) durch Anwenden des anisotropen Ätzprozesses derart gebildet wird, dass ein gedünnter Abschnitt des Substrats (200) verbleibt, der eine Dicke zwischen 20 µm und 150 µm aufweist und der die endgültige Dicke des Umgebungsbarrierechips (500) definiert.

14. Mikromechanikumgebungsbarrierechip (500), der durch ein Verfahren gemäß einem der vorhergehenden Ansprüche hergestellt ist.

## Revendications

1. Un procédé de fabrication d'une puce (500) micromécanique barrière environnementale, le procédé comprenant :
se procurer un substrat (200) ayant une première surface (201) de substrat et une deuxième surface (202) opposée de substrat,
déposer une couche (210) de matière sur la première surface (201) de substrat, la couche (210) de matière ayant une caractéristique de gravure différente de celle du substrat (200),
créer une structure (220) de barrière micromécanique environnementale perméable à l'air et micro-structurée au sommet de la couche (210) de matière en appliquant une opération de micro structuration,
appliquer une opération de gravure anisotrope comprenant au moins une étape de gravure pour graver de manière anisotrope dans le substrat (200) jusqu'à atteindre la couche (210) de matière, de manière à créer au moins une première cavité (230) opposée à la structure (220) de barrière micromécanique environnementale,
enlever la couche (210) de matière résidant à l'intérieur de la cavité, afin de mettre à nu la structure (220) de barrière environnementale, et
appliquer des nanofibres (240) sur la structure (220) micromécanique de barrière environnementale, de manière à ce que les nanofibres (240) se combinent pour former une structure de membrane de nanofibres perméable à l'air.

2. Le procédé suivant la revendication 1,
dans lequel les nanofibres (240) sont appliquées soit sur l'une d'une première face (251) ou d'une deuxième face (252) de la structure (220) micromécanique de barrière environnementale, soit
dans lequel les nanofibres (240) sont appliquées à la fois sur la première et la deuxième faces (251, 252) de la structure (220) micromécanique de barrière environnementale.

3. Le procédé suivant la revendication 1 ou 2,
dans lequel l'étape d'application des nanofibres (240) comprend au moins l'un de :
• disposer une couche favorisant l'adhérence entre les nanofibres (240) et la structure (220) micromécanique de barrière environnementale,
• augmenter une rugosité de surface de la structure (220) micromécanique de barrière environnementale, et
• appliquer une modification en trois dimensions à la structure (220) micromécanique de barrière environnementale,
pour améliorer une adhérence entre les nanofibres (240) et la structure (220) micromécanique de barrière environnementale.

4. Le procédé suivant l'une quelconque des revendications précédentes,
comprenant en outre une étape d'application d'une modification superficielle par la chimie aux nanofibres (240) appliquées en déposant au moins l'un de :
• des monocouches organiques autoassemblées,
• des modifiants à base d'acide stérique, et
• des nanoparticules
sur les nanofibres (240) pour diminuer l'énergie superficielle des nanofibres (240) en produisant une hydrophobicité accrue.

5. Le procédé suivant la revendication 4,
dans lequel les monocouches organiques autoassemblées comprennent ou consistent en au moins l'un de :
• du perfluorodécyltrichlorosilane (FDTS),
• de l'heptadécafluoro-1,1,2,2-tétrahydrodécyl-trichlorosilane (HDFS),
• du tridécafluoro-1,1,2,2-tétrahydrooctlyltri-chlorosilane (FOTS),
• de l'octadécyltrichlorsilane (ODTS),
• du méthyltriméthoxysilane (MTMS),
• du bis(triméthylsilyl)amine ou de l'héxaméthyl-disilazane (HMDS),
• du (3-aminopropyl)triéthoxysilane (APTES),
• du dichlorodiméthylsilane (DDMS),
• de l'octadécyltriméthoxysilane (OTMS),
• de l'éthyltriéthoxysilane (ETES), et
• 1H,1H,2H,2H-perfluorooctyltriéthoxysilane (HFOTES).

6. Le procédé suivant l'une quelconque des revendications précédentes,
dans lequel la structure (220) micromécanique de barrière environnementale est sous la forme d'une membrane perforée perméable à l'air, ou
dans lequel la structure (220) micromécanique de barrière environnementale est sous la forme d'un maillage perméable à l'air.

7. Le procédé suivant l'une quelconque des revendications précédentes,
dans lequel la structure (220) micromécanique de barrière environnementale est configurée pour laisser passer une quantité d'air déterminée à l'avance tout en empêchant de passer une quantité déterminée à l'avance d'au moins l'un de l'humidité, des liquides, de l'huile et des particules solides environnementales.

8. Le procédé suivant l'une quelconque des revendications précédentes,
dans lequel le procédé est effectué à un niveau de plaquette, dans lequel le substrat (200) est une plaquette à partir de laquelle une pluralité de puces (500) micromécaniques de barrière environnementale peut être produite, et
dans lequel le procédé comprend en outre une étape de singularisation de ladite pluralité de puces (500) micromécaniques de barrière environnementale à partir de ladite plaquette (200).

9. Le procédé de l'une quelconque des revendications précédentes,
dans lequel la première cavité (230) comprend une étendue (301) latérale, qui est inférieure ou égale au contour (302) extérieur de la structure (220) micromécanique de barrière environnementale,
dans lequel l'étape d'application d'une opération de gravure anisotrope comprend en outre
appliquer une étape de gravure anisotrope pour graver de manière anisotrope une deuxième cavité (231) dans le substrat (200), la deuxième cavité (231) comprenant une étendue (303) latérale plus grande que la première cavité (230), et
appliquer une autre étape de gravure anisotrope pour graver de manière anisotrope une pluralité de tranchées (260) continues dans le substrat (200), la pluralité de tranchées (260) continues entourant latéralement la structure (220) micromécanique de barrière environnementale et s'étendant verticalement entre la première surface (201) du substrat (200) et la deuxième cavité (231).

10. Le procédé suivant la revendication 9,
dans lequel la pluralité de tranchées (260) continues définit la dimension latérale de la puce (500) micromécanique de barrière environnementale.

11. Le procédé suivant la revendication 9 ou 10,
dans lequel l'étape de gravure de la pluralité de tranchées (260) continues dans le substrat (200) comprend une étape dans laquelle on laisse des parties (290) de la matière du substrat entre la pluralité de tranchées (260) continues, de manière à ce que les parties (290) laissées forment de micro-poutres (290), qui relient structuralement la puce (500) micromécanique de barrière environnementale d'un côté de la pluralité de tranchées (260) continues au substrat (200) sur un autre côté opposé de la pluralité de tranchées (260) continues.

12. Le procédé suivant la revendication 11,
comprenant en outre une étape de rupture des micro-poutres (290) pour désassembler structuralement la puce (500) micromécanique de barrière environnementale du substrat (200) en singularisant ainsi la puce (500) micromécanique de barrière environnementale.

13. Le procédé suivant les revendications 9 à 12,
dans lequel, avant d'appliquer l'opération de gravure anisotrope, le substrat (200) comprend une épaisseur à mesurer entre la première et la deuxième surfaces (201, 202) du substrat (200), ladite épaisseur étant comprise entre 200 µm et 500 µm, et
dans lequel la deuxième cavité (231) est formée en appliquant l'opération de gravure anisotrope, de manière à ce qu'il reste une partie amincie du substrat (200), qui a une épaisseur allant de 20 µm à 150 um et qui définit l'épaisseur finale de la puce (500) de barrière environnementale.

14. Une puce (500) micromécanique de barrière environnementale fabriquée par un procédé suivant l'une quelconque des revendications précédentes.
